# EUROPÄISCHE PATENTSCHRIFT

(11) **EP 1 660 763 B1**
(45) Veröffentlichungstag und Bekanntmachung des Hinweises auf die Patenterteilung: **29.10.2008**
(21) Anmeldenummer: 04764404.2
(22) Anmeldetag: 24.08.2004
(51) Int. Cl.: F02D 11/10

(54) **STELLVORRICHTUNG INSBESONDERE FÜR EINE DROSSELKLAPPE EINER BRENNKRAFTMASCHINE**
ADJUSTING DEVICE, ESPECIALLY FOR THE THROTTLE VALVE OF AN INTERNAL COMBUSTION ENGINE
DISPOSITIF DE POSITIONNEMENT CONÇU EN PARTICULIER POUR UN PAPILLON DE MOTEUR A COMBUSTION INTERNE

(30) Priorität: 05.09.2003 DE 10341394
(43) Veröffentlichungstag der Anmeldung: 31.05.2006
(73) Patentinhaber: Pierburg GmbH, 41460 Neuss (DE)
(72) Erfinder: NEISE, Ralf, 13086 Berlin (DE)
(74) Vertreter: Patentanwälte ter Smitten
(86) Internationale Anmeldenummer: PCT/EP2004/009424
(87) Internationale Veröffentlichungsnummer: WO 2005/028834

(56) Entgegenhaltungen:
- EP-A- 0 456 887
- EP-A- 1 028 239
- DE-A- 4 405 439
- US-A- 5 672 818
- US-A- 5 737 188

## Beschreibung

Die Erfindung betrifft eine Stellvorrichtung, insbesondere eine Klappenstellvorrichtung einer Verbrennungskraftmaschine mit einem Elektromotor und einer Getriebeeinheit, welche in einem Gehäuse angeordnet ist, welches über einen Deckel verschließbar ist, wobei im Gehäuse elektrische Leiterbahnen zur Verbindung der Anschlußkontakte des Elektromotors und einer Positionserfassungseinrichtung zu einem Stecker der Stellvorrichtung angeordnet sind.

Stellvorrichtungen, bei denen eine Klappenwelle mit darauf fest angeordneten Klappen von einem Elektromotor indirekt über eine Getriebeeinheit in Drehung versetzt werden, sind allgemein bekannt und werden in einer Vielzahl von Anmeldungen beschrieben. Die elektrische Kontaktierung zwischen den Anschlußkontakten des Elektromotors beziehungsweise einer Positionserfassungseinrichtung zu einem entsprechenden Stecker, der in seiner Ausführung je nach Kunde variiert, wird dabei auf unterschiedliche Weise verwirklicht.

Während man in der Vergangenheit häufig bewegliche Kabel an den Kontaktstellen verlötet hat, ist man in den letzten Jahren dazu übergegangen, die Kontakte über auf eine Platine gedruckte Leiterbahnen zu verwirklichen. Bekannt sind ebenso Ausführungen bei denen die Leiterbahnen direkt auf eine Kontaktplatte eines Gehäuses oder eines Deckels der Stellvorrichtung gedruckt sind. Ebenfalls bekannt sind Ausführungen, bei denen die metallischen Leiterbahnen direkt in den Kunststoff eingespritzt werden beziehungsweise die Leiterbahnen mit Kunststoff umspritzt werden. Aus neueren Anwendungen ist es auch bekannt, die Leiterbahnen aus einem elektrisch leitenden Kunststoff herzustellen und diesen auf die Platine oder das Gehäuse aufzuspritzen, wobei diese Ausführung den Nachteil aufweist, daß die Kontaktierung insbesondere bei einer höheren mechanischen Belastung nicht ausreichend zuverlässig ist, da die aufgespritzten Leiterbahnen brechen.

Alle diese Ausführungsformen weisen jedoch den Nachteil auf, daß die kompletten Platinen oder sogar Gehäuseteile für jede neue Kundenanforderung bezüglich der Kontaktierung neu konstruiert und hergestellt werden muss, beispielsweise je nachdem wie viele Anschlußkontakte notwendig sind oder was für eine Positionserfassungseinrichtung verwendet wird. Entsprechend muss auch die Fertigung umgestellt werden. Einzige Ausnahme bilden die frei beweglichen Kabel, die in früheren Zeiten verwendet wurden, wobei eine solche Anbindung in dem heute eingeschränkten Bauraum äußerst schwierig durchzuführen ist und einen erhöhten Herstellungsaufwand und Montageaufwand durch die einzelnen Verlötungen zur Folge hat.

Daher ist es Aufgabe der Erfindung, eine Stellvorrichtung bereit zu stellen, bei der ein baugleiches Gehäuse für verschiedene Anforderungen der Kunden bezüglich der Verwendung unterschiedlicher Motore, Anschlussstecker und Positionserfassungseinrichtungen verwenden zu können. Dementsprechend soll auch ein Austausch kompletter Platinen oder Gehäuseteile bei auftretenden elektronischen Fehlfunktionen vermieden werden.

Diese Aufgabe wird dadurch gelöst, daß die elektrischen Leiterbahnen als mit dem Gehäuse formschlüssig verbindbare Stanzteile ausgeführt sind, welche eine definierte Form aufweisen, wobei die Leiterbahnen mit dem Stecker auswechselbar sind. Die Kontaktierung zwischen dem Elektromotor beziehungsweise der Positionserfassungseinrichtung sowie dem Stecker ist damit so ausgeführt, daß es möglich ist, lediglich die Leiterbahnen mit dem Steckerteil aber ohne zusätzliche Gehäuseteile auszutauschen oder hinzuzufügen. Die Grundbauformen des Gehäuses, auf oder an denen die Leiterbahnen befestigt sind, kann auch bei unterschiedlichen notwendigen Kontaktierungen und Steckerausführungen aufgrund unterschiedlicher Kundenwünsche, beispielsweise verschiedener Positionserfassungseinrichtungen, beibehalten werden, ohne die Formen und somit die Werkzeuge zur Herstellung der Gehäuse verändern zu müssen. Somit entsteht eine hohe Flexibilität in der Anbindung der elektrischen Anbauteile.

In einer bevorzugten Ausführungsform sind die Leiterbahnen als Stanzkamm ausgeführt, wobei eine Verbindung der einzelnen Leiterbahnen über Stege besteht, welche durch einen Stanzvorgang nach dem Einlegen des Stanzkamms ins Gehäuse trennbar ist. Dies hat den Vorteil, daß die gesamte elektrische Verbindung als ein Teil austauschbar ist und somit einfach herzustellen und vor allem zu montieren ist. Das Gehäuseteil, in welches der Stanzkamm eingelegt wird, ist dabei so ausgeführt, daß im Bereich der Stege entsprechende Ausnehmungen angeordnet sind, in welche ein Werkzeug zum Trennen der einzelnen Leiterbahnen eingreifen kann.

In einer bevorzugten Ausführungsform münden jeweils erste Enden der Leiterba h-nen im Stecker, in welchem sie mit ausgestanzten Rastnasen einrasten oder mit Kunststoff umspritzt sind. So entsteht auf einfache Weise eine zuverlässige Konta k-tierung und gleichzeitig eine Abdichtung des im Gehäuse angeordneten Steckerteils gegen die außenliegende Atmosphäre, wobei der Stecker sowohl einteilig mit dem Gehäuse als auch voneinander trennbar also zweiteilig ausgeführt sein kann.

In einer alternativen Ausführungsform münden die jeweils ersten Enden der Leiterbahnen am Stecker, wo über eine Pressverbindung ein elektrischer Kontakt zu Pins des Steckers herstellbar ist. So kann das Steckerteil einzeln gefertigt werden und erst in einem darauf folgenden Montageschritt mit den Leiterbahnen über diese Pressverbindung verbunden werden.

Ebenso ist es vorteilhaft, wenn jeweils zweite Enden der den Kontakt zum Motor herstellenden Leiterbahnen in Aufnahmetaschen des Gehäuses gesteckt sind, wo sie eine kraftschlüssige Verbindung zu Kontaktfahnen des Elektromotors herstellen. Dadurch kann bei der Montage durch einfaches Einstecken des Elektromotors und der Leiterbahn ohne zusätzliche Herstellungs- oder Montageschritte die notwendige Verbindung hergestellt werden, wodurch Montagekosten reduziert werden.

Des weiteren sind die jeweils zweiten Enden der den Kontakt zur Positionserfassungseinrichtung herstellenden Leiterbahnen vorteilhafterweise derart geformt, daß eine Verbindung zu den Anschlußkontakten der Positionserfassungseinrichtung durch ein Verspannen der zweiten Enden der Leiterbahnen gegenüber einem Bauteil der Positionserfassungseinrichtung herstellbar ist.

In einer besonderen Ausführung kann die Positionserfassungseinrichtung ein Potentiometer sein, wobei die jeweils zweiten Enden der den Kontakt zum Potentiometer herstellenden Leiterbahnen derart geformt sind, daß eine Verbindung zu Schleiferbahnen des Potentiometers durch Verspannen der Endstücke der zweiten Enden der Leiterbahnen gegenüber einer Potentiometerplatine herstellbar ist. Dabei kann die Potentiometerplatine entweder einstückig mit dem Gehäusedeckel oder im Gehäuse selbst ausgeführt sein oder aber als einzelnes Bauteil mit dem Gehäuse verbunden werden. In allen Fällen ergibt sich eine einfache Kontaktierung ohne zusätzliche Montageschritte.

In einer bevorzugten Ausführungsform sind die Leiterbahnen im Bereich ihrer jeweiligen Enden und ihrer Stege formschlüssig am Gehäuse befestigt, so daß ein axiales Verschieben der Leiterbahnen verhindert wird.

In einer weiterführenden Ausführungsform greifen die Stege der Stanzkämme in Ausnehmungen am Gehäuse derart ein, daß die formschlüssige Verbindung hergestellt ist. Hierdurch kann in nur einem Arbeitsschritt sowohl das Trennen der einzelnen Leiterbahnen voneinander als auch ihre Fixierung am Gehäuse erfolgen, so daß Montageschritte eingespart werden können.

In einer alternativen Ausgestaltung erfolgt die formschlüssige Verbindung durch Warmverstemmen von Nasen der Kontaktplatte auf die Leiterbahnen.

In einer weiteren alternativen Ausführungsform ist ein Dichtklebstoff an zumindest einer Position der Leiterbahnen und/oder im Bereich der Verbindung zwischen den Pins des Steckers und den Leiterbahnen aufgebracht, wodurch die Fixierung der Leiterbahnen am Stecker, beziehungsweise am Gehäuse wiederum auf einfache Art und Weise verwirklicht wird.

Es wird somit eine Stellvorrichtung geschaffen, mit welcher die Kontaktierung in einem Gehäuse einer Stellvorrichtung zuverlässig sicher gestellt wird und dabei eine hohe Flexibilität bezüglich der Anzahl beziehungsweise der Lage der Leiterbahnen sowie des Anschlusses zu einem kundenseitig gewünschten Stecker erreicht. Hierdurch kann die Stückzahl gleicher Bauteile der Stellvorrichtung erhöht werden, so daß weitere Kosten eingespart werden können. Ein Austauschen der elektrischen Kontaktierung ist möglich, ohne weitere Teile mit austauschen zu müssen.

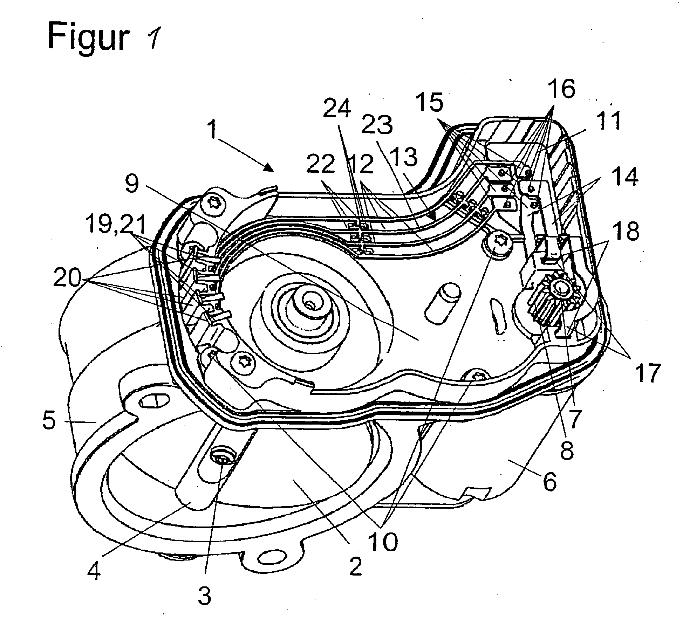

Eine erfindungsgemäße Stellvorrichtung ist in der Zeichnung dargestellt und wird nachfolgend beschrieben.

Die Figur zeigt in dreidimensionaler Darstellung ein geöffnetes Gehäuse einer erfindungsgemäßen Stellvorrichtung am Beispiel einer Drosselklappenstellvorrichtung.

Die in der Figur dargestellte Stellvorrichtung 1 wird hier beispielhaft zur Verstellung einer Drosselklappe 2, welche über Schrauben 3 auf einer Welle 4 befestigt ist und welche in einem Drosselklappenstutzen 5 angeordnet ist, verwendet. Die Stellvorrichtung 1 besteht aus einem Elektromotor 6, auf dessen Motorwelle 7 ein Zahnrad 8 angeordnet ist, welches über ein weiterführendes nicht dargestelltes Untersetzungsgetriebe, die Drosselklappenwelle 4 antreibt. Das Getriebe, die elektrische Kontaktierung sowie gegebenenfalls der Elektromotor sind in einem Gehäuse 9 angeordnet, welches über Schrauben 10 am Drosselklappenstutzen 5 befestigt ist und durch einen nicht dargestellten Deckel verschlossen wird.

Die elektrische Kontaktierung von einem Stecker 11 zu einer nicht näher dargestellten Positionserfassungseinrichtung erfolgt über gestanzte Leiterbahnen 12, welche zusammenhängend als Stanzkamm 13 in das Gehäuse 9 eingebracht werden. Die Kontaktierung vom Stecker 11 zu den nicht dargestellten Kontaktfahnen des Elektromotors 6 erfolgt über weitere gestanzte Leiterbahnen 14.

Jeweils erste Enden 15 der Leiterbahnen 12, 14 sind über eine Pressverbindung mit Pins 16 des Steckers 11, welche an der gegenüberliegenden Seite des Gehäuses 9 aus dem Gehäuse 9 austreten, verbunden. Zur zusätzlichen Sicherung und Abdichtung dieser Verbindung kann im Bereich des Steckers 11 ein Dichtklebstoff aufgebracht werden. Es wäre auch denkbar, die Leiterbahnen 12, 14 so auszuführen, daß ihre ersten Enden 15 jeweils um 90 Grad gebogen sind und über Rastnasen durch das Gehäuse hindurch treten und so gleichzeitig als Pins 16 des Steckers 11 dienen, wobei bei einer solchen Ausführung eine Abdichtung zwischen dem Gehäuse 9 und den Pins 16 beziehungsweise ersten Enden 15 der Leiterbahnen 12, 14 gewährleistet werden müsste.

Zweite Enden 17 der Leiterbahnen 14 zur Kontaktierung des Elektromotors 6 sind so ausgeformt, daß sie in axialer Richtung weisen und dort in Aufnahmetaschen 18 greifen, wo durch das Einschieben der Enden 17 in die Aufnahmetaschen 18 eine kraftschlüssige Verbindung zu nicht dargestellten Anschlußkontakten des Elektromotors 6 hergestellt wird. Dies wird dadurch gewährleistet, daß die zweiten Enden 17 federnd an einer Seite der Aufnahmetaschen 18 anliegen, an der auch die Motoranschlusskontake liegen, so daß der Kontakt zu den Kontaktfahnen des Motors 6 kraftschlüssig sicher gestellt wird. Die dargestellten zweiten Enden 19 der Leiterbahnen 12 sind zur Kontaktierung von nicht dargestellten Schleiferbahnen eines nicht dargestellten Potentiometers derart ausgeführt, dass die ansonsten quer zur Achsrichtung verlaufenden Leiterbahnen 12 in diesem Bereich 19 zunächst um 90 Grad gebogen sind, wobei dieser Teil in Aufnahmetaschen 20 angeordnet ist und dann wiederum um einen Winkel kleiner 90 Grad gebogen werden. Diese Endstücke 21 reichen aus den Aufnahmetaschen 19 derart heraus, daß eine Verformbarkeit dieser Endstücke 21 in Achsrichtung besteht. Beim anschließenden Montieren einer Potentiometerplatine mit darauf angeordneten Schleiferbahnen, welche nicht dargestellt ist, wird diese so auf die Endstücke 21 gedrückt, daß diese in Richtung zur Drosselklappe federnd gebogen werden, so daß eine kraftschlüssige Verbindung zu den Schleiferbahnen des Potentiometers hergestellt wird.

Die Leiterbahnen 12 werden wie erwähnt als Stanzkamm 13 ausgeführt, wobei zwischen den einzelnen Leiterbahnen Stege 22 angeordnet sind. Diese Stege 22 können falls notwendig zur Fixierung der mittleren Abschnitte 23 der Leiterbahnen 12 verwendet werden, indem beim Trennen der Stege 22 diese soweit umgebogen werden, daß sie in entsprechende Ausnehmungen 24 des Gehäuses 9 eingreifen, so daß eine formschlüssige Verbindung zwischen Gehäuse 9 und den Leiterbahnen 12 die Folge ist. Dies erfolgt insbesondere dann, wenn die Fixierung durch den Anschluß am Stecker beziehungsweise durch die Aufnahme der Leiterbahnenden 19 in den Aufnahmetaschen 20 zur axialen Fixierung der im wesentlichen quer zur Achsrichtung verlaufenden Leiterbahnen 12 nicht ausreicht.

Eine alternative Möglichkeit zur Befestigung der mittleren Abschnitte 23 der Leiterbahnen 12, 14 kann erfolgen, indem durch Warmverstemmen am Gehäuse 9 ausgebildete nicht dargestellte Nasen auf die Leiterbahnen 12, 14 gedrückt werden. Auch eine Verklebung mit Hilfe eines Dichtklebemittels ist denkbar.

Diese Ausführungsform zeigt, daß die Kontaktierung über Leiterbahnen, welche im wesentlichen frei im Gehäuse liegen auf einfache Art und Weise erfolgen kann, wobei Montageschritte durch die kraftschlüssigen Verbindungen eingespart werden, die Leiterbahnen dennoch im Gehäuse fixiert sind und unabhängig vom Gehäuse ausgetauscht werden können. Der Montageaufwand wächst im Vergleich zu bekannten Ausführungen nicht, da alle Leiterbahnen gemeinsam als Stanzkamm ausgeführt sind und in das Gehäuse eingebracht werden können.

## Patentansprüche

1. Stellvorrichtung, insbesondere für einen Klappenantrieb einer Verbrennungskraftmaschine mit einem Elektromotor und einer Getriebeeinheit, welche in einem Gehäuse angeordnet ist, welches über einen Deckel verschließbar ist, wobei im Gehäuse elektrische Leiterbahnen zur Verbindung der Anschlußkontakte des Elektromotors und einer Positionserfassungseinrichtung zu einem Stecker der Stellvorrichtung angeordnet sind, **dadurch gekennzeichnet, daß** die elektrischen Leiterbahnen (12,14) als mit dem Gehäuse (9) formschlüssig verbindbare Stanzteile ausgeführt sind, welche eine definierte Form aufweisen, wobei die Leiterbahnen (12,14) mit dem Stecker (11) auswechselbar sind.

2. Stellvorrichtung nach Anspruch 1, **dadurch gekennzeichnet, daß** die Leiterbahnen (12,14) als Stanzkamm (13) ausgeführt sind, wobei eine Verbindung der einzelnen Leiterbahnen (12, 14) über Stege (22) besteht, welche durch einen Stanzvorgang nach dem Einlegen des Stanzkamms (13) ins Gehäuse (9) trennbar ist.

3. Stellvorrichtung nach Anspruch 1 oder 2, **dadurch gekennzeichnet, daß** jeweils erste Enden (15) der Leiterbahnen (12,14) im Stecker (11) münden, in welchem sie mit ausgestanzten Rastnasen einrasten oder mit Kunststoff umspritzt sind.

4. Stellvorrichtung nach einem der Ansprüche 1 oder 2, **dadurch gekennzeichnet, daß** die jeweils ersten Enden (15) der Leiterbahnen (12,14) am Stecker (11) münden, wo über eine Pressverbindung ein elektrischer Kontakt zu Pins (16) des Steckers (11) herstellbar ist.

5. Stellvorrichtung nach einem der vorhergehenden Ansprüche, **dadurch gekennzeichnet, daß** jeweils zweite Enden (17) der den Kontakt zum Motor (6) herstellenden Leiterbahnen (12) in Aufnahmetaschen (18) des Gehäuses (9) gesteckt sind, wo sie eine kraftschlüssige Verbindung zu Kontaktfahnen des Elektromotors (6) herstellen.

6. Stellvorrichtung nach einem der vorhergehenden Ansprüche, **dadurch gekennzeichnet, daß** die jeweils zweiten Enden (19) der den Kontakt zur Positionserfassungseinrichtung herstellenden Leiterbahnen (12) derart geformt sind, daß eine Verbindung zu den Anschlußkontakten der Positionserfassungseinrichtung durch ein Verspannen der zweiten Enden (19) der Leiterbahnen (12) gegenüber einem Bauteil der Positionserfassungseinrichtung herstellbar ist.

7. Stellvorrichtung nach Anspruch 6, **dadurch gekennzeichnet, daß** die Positionserfassungseinrichtung ein Potentiometer ist, wobei die jeweils zweiten Enden (19) der den Kontakt zum Potentiometer herstellenden Leiterbahnen (12) derart geformt sind, daß eine Verbindung zu Schleiferbahnen des Potentiometers durch Verspannen von Endstücken (21) der zweiten Enden (19) der Leiterbahnen (12) gegenüber einer Potentiometerplatine herstellbar ist.

8. Stellvorrichtung nach einem der vorhergehenden Ansprüche, **dadurch gekennzeichnet, daß** die Leiterbahnen (12,14) im Bereich ihrer jeweiligen Enden (17,19) und ihrer Stege (22) formschlüssig am Gehäuse (9) befestigt sind.

9. Stellvorrichtung nach einem der Anspruch 8, **dadurch gekennzeichnet, daß** die Stege (22) der Stanzkämme (13) in Ausnehmungen (24) am Gehäuse (9) derart eingreifen, daß die formschlüssige Verbindung hergestellt ist.

10. Stellvorrichtung nach einem der Ansprüch 1 bis 7, **dadurch gekennzeichnet, daß** die formschlüssige Verbindung durch Warmverstemmen von Nasen des Gehäuses (9) auf die Leiterbahnen (12,14) erfolgt.

11. Stellvorrichtung nach einem der Ansprüche 1 bis 7, **dadurch gekennzeichnet, daß** ein Dichtklebstoff an zumindest einer Position der Leiterbahnen (12,14) und/oder im Bereich der Verbindung zwischen den Pins (16) des Steckers (11) und den Leiterbahnen (12,14) aufgebracht ist.

## Claims

1. An adjusting device, especially for a valve drive of an internal combustion engine comprising an electric motor and a transmission unit which is arranged in a housing adapted to be closed with a lid, electric conductors being provided in the housing for connecting the connecting contacts of the electric motor and a position sensing means to a plug of the adjusting device, **characterized in that** the electric conductors (12, 14) are configured as punched parts connectable with the housing (9) in a form-fitting manner, said parts having a defined shape, wherein the conductors (12, 14) are exchangeable together with the plug (11).

2. The adjusting device of claim 1, **characterized in that** the conductors (12, 14) are configured as a punched comb (13), wherein the individual conductors (12, 14) are connected through webs (22), said connection being severable by a punching operation after the punched comb (13) has been placed in the housing (9).

3. The adjusting device of claim 1 or 2, **characterized in that** respective first ends (15) of the conductors (12, 14) end in the plug (11) in which they lock by means of punched locking noses or in which they are overmolded.

4. The adjusting device of one of claims 1 or 2, **characterized in that** the respective first ends (15) of the conductors (12, 14) end at the plug (11), where an electric contact with pins (16) of the plug (11) can be made by a press-fit connection.

5. The adjustment device of one of the preceding claims, **characterized in that** respective second ends (17) of the conductors (14) making contact with the motor (6) are set into receiving pockets (18) of the housing (9), where they make a force-fit connection with contact tabs of the electric motor (6).

6. The adjustment device of one of the preceding claims, **characterized in that** the respective second ends (19) of the conductors (12) making contact with the position sensing means are shaped such that a connection with the connecting contacts of the position sensing means can be realized by clamping the second ends (19) of the conductors (12) with respect to a component of the position sensing means.

7. The adjustment device of claim 6, **characterized in that** the position sensing means is a potentiometer, wherein the respective second ends (19) of the conductors (12) making contact with the potentiometer are shaped such that a connection with slideways of the potentiometer can be realized by clamping end pieces (21) of the second ends (19) of the conductors (12) with respect to a potentiometer circuit board.

8. The adjusting device of one of the preceding claims, **characterized in that** the conductors (12, 14) are fastened to the housing (9) in a form-fit manner in the region of their respective ends (17, 19) and their webs (22).

9. The adjusting device of claim 8, **characterized in that** the webs (22) of the punched combs (13) engage in recesses (24) in the housing (9) such that the form-fit connection is established.

10. The adjusting device of one of claims 1 to 7, **characterized in that** the form-fit connection is effected by warm press fitting of noses of the housing (9) onto the conductors (12, 14).

11. The adjusting device of one of claims 1 to 7, **characterized in that** a sealing adhesive is applied at at least one position of the conductors (12, 14) and/or in the region of the connection between the pins (16) of the plug (11) and the conductors (12, 14).

## Revendications

1. Dispositif de positionnement conçu en particulier pour l'entraînement d'un papillon de moteur de combustion interne comprenant un moteur électrique et un ensemble de transmission prévu dans un boîtier apte à être fermé par un couvercle, des pistes conductrices électriques étant disposées dans le boîtier pour la connexion des bornes de raccord du moteur électrique et d'un moyen de captage de position à un connecteur du dispositif de positionnement, **caractérisé en ce que** les pistes conductrices électriques (12, 14) sont conçues comme pièces découpées aptes à être raccordées au boîtier (9) de manière positif et ayant une forme définie, les pistes conductrices (12, 14) étant échangeables avec le connecteur (11).

2. Dispositif de positionnement selon la revendication 1, **caractérisé en ce que** les pistes conductrices (12, 14) sont façonnées comme un élément à découper en forme de peigne (13), la connexion entre les pistes conductrices (12, 14) individuelles étant réalisée par des entretoises (22), la connexion étant séparable par une opération de découpage après le placement du peigne à découper (13) dans le boîtier (9).

3. Dispositif de positionnement selon la revendication 1 ou 2, **caractérisé en ce que** les premières extrémités (15) respectives des pistes conductrices (12, 14) se terminent dans le connecteur (11) dans lequel ils s'engagent par des talons d'arrêt découpés ou sont surmoulées en matière plastique.

4. Dispositif de positionnement selon une des revendications 1 ou 2, **caractérisé** les premières extrémités (15) respectives des pistes conductrices (12, 14) se terminent au connecteur (11) où le contact électrique avec des bornes (16) du connecteur (11) peut être établi par une connexion sertie.

5. Dispositif de positionnement selon une des revendications précédentes, **caractérisé en ce que** les deuxièmes extrémités (17) respectives des pistes conductrices (14) réalisant le contact avec le moteur (6) sont mises dans des poches réceptrices (18) du boîtier (9) où elles établissent une connexion par adhérence avec des lames de contact du moteur électrique (6).

6. Dispositif de positionnement selon une des revendications précédentes, **caractérisé en ce que** les deuxièmes extrémités (19) respectives des pistes conductrices (12) réalisant le contact avec le moyen de captage de position sont formées de manière qu'une connexion avec les bornes de raccord du moyen de captage de position peut être réalisée par serrage des deuxième extrémités (19) des pistes conductrices (12) par rapport à un élément du moyen de captage de position.

7. Dispositif de positionnement selon la revendication 6, **caractérisé en ce que** le moye de captage de position est un potentiomètre, les deuxièmes extrémités (19) respectives des pistes conductrices (14) réalisant le contact avec le potentiomètre sont formées de manière qu'une connexion avec des bandes de glissement du potentiomètre peut être établie par serrage de parties d'extrémité (21) des deuxièmes extrémités (19) des pistes conductrices (12) par rapport à une platine du potentiomètre.

8. Dispositif de positionnement selon une des revendications précédentes, **caractérisé en ce que** les pistes conductrices (12, 14) sont fixées de manière positive au boîtier (9) dans la région de leurs extrémités respectives (17, 19) et leurs entretoises (22).

9. Dispositif de positionnement selon la revendication 8, **caractérisé en ce que** les entretoises (22) des peignes à découper (13) s'engage dans des creux (24) sur le boîtier (9) de sorte que la connexion positive est établie.

10. Dispositif de positionnement selon une des revendications 1 à 7, **caractérisé en ce que** la connexion positive est réalisée par matage à chaud de talons du boîtier (9) sur les pistes conductrices (12, 14).

11. Dispositif de raccordement selon une des revendications 1 à 7, **caractérisé en ce qu'**un adhésif d'étanchéité est appliqué à au moins une position des pistes conductrices (12, 14) et/ou dans la région de la connexion entre les bornes (16) du connecteur (11) et les pistes conductrices (12, 14).
